# EUROPEAN PATENT APPLICATION

(11) **EP 4 811 967 A1**
(43) Date of publication of application: **23.09.2026**
(21) Application number: 26150232.2
(22) Date of filing: 05.01.2026
(51) Int. Cl.: H10F 10/165, H10F 71/00, H10F 77/1223, H10F 10/166

(54) **SOLAR CELL AND PREPARATION METHOD THEREOF**

(30) Priority: 17.03.2025 CN 202510316679
(71) Applicant: Jinko Solar (Haining) Co., Ltd., Jiaxing, Zhejiang 314415 (CN)
(72) Inventor: WEI, He, Jiaxing, 314415 (CN); WU, Junli, Jiaxing, 314415 (CN); ZHANG, Bike, Jiaxing, 314415 (CN); JIN, Jingsheng, Jiaxing, 314415 (CN)
(74) Representative: DREISS Patentanwälte PartG mbB

(57) **Abstract**

Provided are a solar cell and a preparation method of the solar cell. The solar cell includes a silicon substrate and a stack structure. The stack structure is provided on a rear surface of the silicon substrate along a thickness direction of the solar cell. The silicon substrate and the stacked structure contain antimony element. The stack structure at least includes a first oxide layer, a first doped polycrystalline silicon layer, a second oxide layer and a second doped polycrystalline silicon layer which are sequentially stacked along the thickness direction of the solar cell. An antimony doping concentration in the second oxide layer is higher than an antimony doping concentration in the first doped polycrystalline silicon layer. Antimony element in the stack structure can be bonded with silicon element, thereby effectively improving the passivation effect, solving the problem of low conductivity of carriers, and thus enhancing the working efficiency of the solar cell. The stack structure has a certain concentration gradient characteristic along the thickness direction of the solar cell, which can improve the conductivity of the carriers in the stack structure, and thereby reducing the series resistance of the solar cell.

## Description

### TECHNICAL FIELD

The present disclosure relates to the technical field of photovoltaic cells, and in particular, to a solar cell and a preparation method of the solar cell.

### BACKGROUND

With the continuous growth of demand for renewable energy, solar cells, as an efficient and clean energy conversion method, have attracted widespread attention. As a new type of solar cell technology, TOPCon solar cells have the advantages of high conversion efficiency, low attenuation performance, high mass production cost-effectiveness, and are widely used in the photovoltaic power generation industry. TOPCon cells are usually prepared on a pure phosphorus-doped N-type silicon wafer substrate, resulting in a limited conductivity of the carriers in the structure of the TOPCon solar cell, resulting in a relatively poor electrical conductivity and affecting the working efficiency of the TOPCon solar cell.

### SUMMARY

The present disclosure provides a solar cell and a preparation method of the solar cell, so as to solve the technical problem of low conductivity of the carriers in a solar cell structure in the related art.

In some embodiments, an embodiment of the present disclosure provides a solar cell including a silicon substrate and a stack structure. Along a thickness direction of the solar cell, the stack structure is provided on a rear surface of the silicon substrate. The silicon substrate and the stack structure contain antimony element. The stack structure at least includes a first oxide layer, a first doped polycrystalline silicon layer, a second oxide layer and a second doped polycrystalline silicon layer which are sequentially stacked along the thickness direction of the solar cell. An antimony doping concentration (i.e. doping concentration of the antimony element) in the second oxide layer is higher than an antimony doping concentration in the first doped polycrystalline silicon layer.

In some embodiments, when the silicon substrate of the solar cell contains antimony element, antimony element can diffuse out into the stack structure to a certain extent. Antimony element diffused out into the stack structure can be bonded with silicon element, thereby avoiding the formation of voids in the stack structure, effectively improving the passivation effect, solving the problem of low conductivity of the carriers, and thus enhancing the working efficiency of the solar cell. The antimony doping concentration in the second oxide layer in the stack structure is higher than the antimony doping concentration in the first doped polycrystalline silicon layer, thereby enabling the stack structure to have a certain concentration gradient characteristic along the thickness direction of the solar cell, improving the conductivity of the carriers in the stack structure, reducing the series resistance of the solar cell, improving the filling factor and the open-circuit voltage of the solar cell, and thus further improving the working efficiency of the solar cell. Additionally, since the second oxide layer has a stronger absorption and blocking effect on antimony element than the first doped polycrystalline silicon layer, the second oxide layer can also block most of antimony element from continuously diffusing away from the silicon substrate, thereby maintaining the passivation effect.

In addition, compared with the related art in which the stack structure of the solar cell only includes one layer of oxide layer and one layer of doped polycrystalline silicon layer, the stack structure of the solar cell in the embodiments of the present disclosure may be provided with two layers of oxide layer and two layers of polycrystalline silicon layer, which can further improve the passivation effect of the solar cell, thereby further improving the working efficiency of the solar cell.

In some embodiments, the first oxide layer, the first doped polycrystalline silicon layer, the second oxide layer and the second doped polycrystalline silicon layer have different doping concentrations of antimony element.

In some embodiments, the antimony doping concentration in the first oxide layer is higher than the antimony doping concentration in the first doped polycrystalline silicon layer, and the antimony doping concentration in the second oxide layer is higher than the antimony doping concentration in the second doped polycrystalline silicon layer.

In some embodiments, the antimony doping concentration in the first oxide layer is higher than the antimony doping concentration in the second oxide layer, and the antimony doping concentration in the second oxide layer is higher than an antimony doping concentration in the silicon substrate.

In some embodiments, the solar cell satisfies at least one of the following conditions. The antimony doping concentration in the first oxide layer is in a range of 5.0×10¹⁶cm⁻³ to 2.0×10¹⁸cm⁻³, the antimony doping concentration in the second oxide layer is in a range of 5.0×10¹⁶cm⁻³ to 2.0×10¹⁸cm⁻³, the antimony doping concentration in the first doped polycrystalline silicon layer is in a range of 2.0×10¹⁶cm⁻³ to 6.0×10¹⁶cm⁻³, the antimony doping concentration in the second doped polycrystalline silicon layer is in a range of 1.0×10¹⁶cm⁻³ to 2.0×10¹⁶cm⁻³.

In some embodiments, the solar cell satisfies at least one of the following conditions: a thickness L1 of the first oxide layer is in a range of 1nm to 2nm, a thickness L2 of the first doped polycrystalline silicon layer is in a range of 100nm to 200nm, a thickness L3 of the second oxide layer is in a range of 1nm to 2nm, and a thickness L4 of the second doped polycrystalline silicon layer is in a range of 100nm to 200nm.

In some embodiments, the solar cell satisfies at least one of the following conditions: the antimony doping concentration in the first oxide layer gradually increases from a side facing the silicon substrate to a side away from the silicon substrate. The antimony doping concentration in the first doped polycrystalline silicon layer first decreases and then increases from a side facing the silicon substrate to a side away from the silicon substrate. The antimony doping concentration in the second oxide layer gradually decreases from a side facing the silicon substrate to a side away from the silicon substrate. The antimony doping concentration in the second doped polycrystalline silicon layer gradually decreases from a side facing the silicon substrate to a side away from the silicon substrate.

In some embodiments, an embodiment of the present disclosure provides a preparation method of a solar cell, including: preparing a silicon substrate containing antimony element; sequentially forming a first oxide layer, a first amorphous silicon layer, a second oxide layer and a second amorphous silicon layer on a rear surface of the silicon substrate; and performing a phosphorus doping process, to convert the first amorphous silicon layer into a first doped polycrystalline silicon layer and to convert the second amorphous silicon layer into a second doped polycrystalline silicon layer. Part of antimony element in the silicon substrate is diffused into the first oxide layer, the first doped polycrystalline silicon layer, the second oxide layer and the second doped polycrystalline silicon layer. An antimony doping concentration in the second oxide layer is higher than an antimony doping concentration in the first doped polycrystalline silicon layer.

In some embodiments, by doping antimony element in the silicon substrate, antimony element in the silicon substrate can diffuse out into the stack structure, which significantly improves the passivation effect of the stack structure, and enables antimony element in the stack structure to have a certain concentration gradient characteristic, and can also improve the conductivity of carriers, thereby reducing the series resistance of the solar cell and improving the working efficiency of the solar cell. Additionally, by doping antimony element in the silicon substrate, during the subsequent phosphorus doping process, antimony element in the silicon substrate can automatically diffuse out into the stack structure and form a certain concentration gradient characteristic under the influence of high temperature during the phosphorus doping process, thereby simplifying the preparation method of the solar cell while meeting the usage requirement, and thus reducing the preparation difficulty.

In some embodiments, when performing the phosphorus doping process, the preparation method of the solar cell specifically includes: a temperature during the phosphorus doping process is in a range of 850°C to 900°C.

In some embodiments, when the silicon substrate is prepared and is configured to contain antimony element, the preparation method of the solar cell further includes: an antimony doping concentration in the silicon substrate is in a range of 5.427×10¹⁶cm⁻³ to 2.042×10¹⁸cm⁻³.

### BRIEF DESCRIPTION OF DRAWINGS

In order to better illustrate the technical solutions in embodiments of the present disclosure, the drawings used in the description of embodiments are briefly described as below. It should be noted that the drawings described below are merely some embodiments of the present disclosure, and other drawings may be obtained by those skilled in the art according to these drawings without paying any creative efforts.
FIG. 1 is a structural schematic diagram of a solar cell according to one or more embodiments of the present disclosure;
FIG. 2 is a structural schematic diagram of a semi-finished solar cell generated in a preparation process of the solar cell according to one or more embodiments of the present disclosure;
FIG. 3 is a structural schematic diagram of the solar cell in FIG. 2 after a phosphorus doping process; and
FIG. 4 shows the concentration gradient of antimony element in the solar cell in FIG. 1.

### Reference signs:

1 - solar cell;
11 - silicon substrate;
12 - stack structure;
   121 - first oxide layer;
   122 - first doped polycrystalline silicon layer;
   123 - second oxide layer;
   124 - second doped polycrystalline silicon layer;
13 - first amorphous silicon layer;
14 - second amorphous silicon layer;
15 - metal electrode;
16 - passivation layer;
17 - emitter.

### DESCRIPTION OF EMBODIMENTS

In order to better understand technical solutions of the present disclosure, embodiments of the present disclosure are described in detail with reference to the drawings.

It should be made clear that the embodiments described are only part of rather than all of the embodiments of the present disclosure. All other embodiments obtained by those skilled in the art without creative efforts according to the embodiments of the present disclosure shall fall within a protection scope of the present disclosure.

The terms used in the embodiments of the present disclosure are only for the purpose of describing specific embodiments, and are not intended to limit the present disclosure. As used in embodiments of the present disclosure and the appended claims, the singular forms "a/an", "said", and "the" are intended to include the plural forms as well, unless the context clearly indicated otherwise.

It should be understood that the term "and/or" used in the context of the present disclosure is to describe a correlation relation of related objects, indicating that there may be three relations, e.g., A and/or B may indicate only A, both A and B, and only B. In addition, the symbol "/" in the context generally indicates that the relation between the objects in front and at the back of "/" is an "or" relationship.

With the continuous growth of demand for renewable energy, solar cells, as an efficient and clean energy conversion method, have attracted widespread attention. As a new type of solar cell technology, TOPCon solar cells have the advantages of high conversion efficiency, low attenuation performance, high mass production cost-effectiveness, and are widely used in the photovoltaic power generation industry. The TOPCon solar cell effectively reduces the interface recombination loss and improves the open-circuit voltage and filling factor of the solar cell by introducing one layer of an ultrathin oxide layer and one layer of a polycrystalline silicon layer on a rear surface of the solar cell. However, the TOPCon solar cell is usually prepared on a pure phosphorus-doped N-type silicon wafer, resulting in a limited conductivity of the carriers in the structure of the TOPCon solar cell, resulting in a relatively poor electrical conductivity, a relatively high series resistance and a relatively low filling factor, and thus resulting in a relatively low working efficiency of TOPCon solar cell.

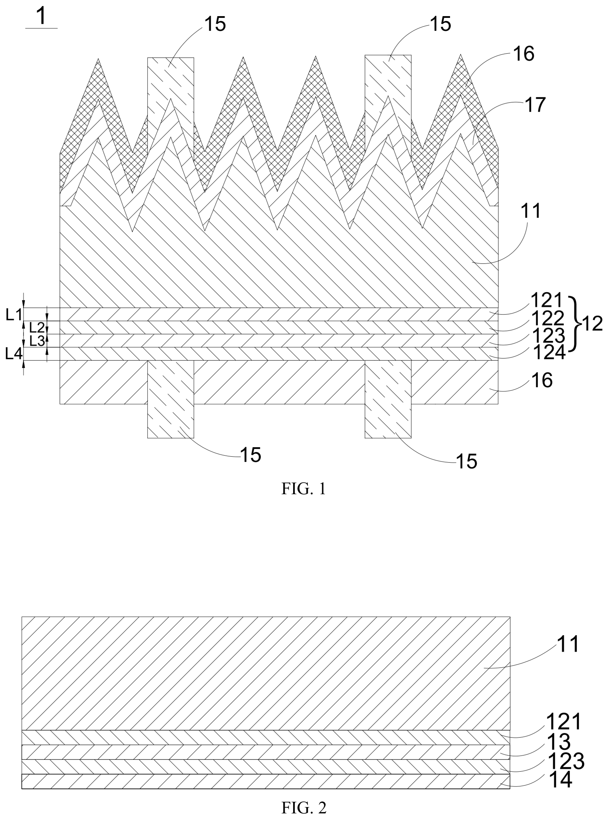

In order to solve the above technical problems, as shown in FIG. 1, the present disclosure provides a solar cell 1 and a preparation method thereof. The solar cell 1 may include a silicon substrate 11 and a stack structure 12. Along a thickness direction of the solar cell 1, the stack structure 12 is provided on a rear surface of the silicon substrate 11. The silicon substrate 11 and the stack structure 12 contain antimony element. The stack structure 12 at least includes a first oxide layer 121, a first doped polycrystalline silicon layer 122, a second oxide layer 123 and a second doped polycrystalline silicon layer 124 which are sequentially stacked along the thickness direction of the solar cell 1. An antimony doping concentration in the second oxide layer 123 is higher than an antimony doping concentration in the first doped polycrystalline silicon layer 122. The oxide layer is tunnel oxide layer.

In some embodiments, when the silicon substrate 11 of the solar cell 1 contains antimony element, antimony element can diffuse out into the stack structure 12 to a certain extent. Antimony element diffused out into the stack structure 12 can be bonded with silicon element, thereby avoiding the formation of voids in the stack structure, effectively improving the passivation effect, solving the problem of low conductivity of the carriers, and thus enhancing the working efficiency of the solar cell 1. The antimony doping concentration in the second oxide layer 123 in the stack structure 12 is higher than the antimony doping concentration in the first doped polycrystalline silicon layer 122, thereby enabling the stack structure 12 to have a certain concentration gradient characteristic along the thickness direction of the solar cell 1, improving the conductivity of the carriers in the stack structure 12, reducing the series resistance of the solar cell 1, improving the filling factor and the open-circuit voltage of the solar cell 1, and thus further improving the working efficiency of the solar cell 1. Additionally, since the second oxide layer 123 has a stronger absorption and blocking effect on antimony element than the first doped polycrystalline silicon layer 122, the second oxide layer 123 can also block most of antimony element from continuously diffusing away from the silicon substrate 11, thereby maintaining the passivation effect.

In some embodiments, the solar cell 1 may be the TOPCon solar cell, as shown in FIG. 1, for the TOPCon solar cell, along its thickness direction, the TOPCon solar cell may sequentially include a metal electrode 15, a passivation layer 16, an emitter 17, a silicon substrate 11, a stack structure 12, a passivation layer 16 and a metal electrode 15. The stack structure 12 may at least include a first oxide layer 121, a first doped polycrystalline silicon layer 122, a second oxide layer 123 and a second doped polycrystalline silicon layer 124, so that the rear surface of the solar cell 1 is composed of the oxide layer and the doped polycrystalline silicon layer. The oxide layer and the doped polycrystalline silicon layer may jointly form a passivation contact structure. This structure may prevent recombination of minority carriers and holes and improve the open-circuit voltage of the solar cell 1.

In some embodiments, the oxide layer may enable majority carriers to tunnel into the doped polycrystalline silicon layer while blocking the recombination of minority carriers, exhibiting excellent passivation effect. The doped polycrystalline silicon layer may induce the bending of the energy band, thereby forming a field passivation effect, which greatly increases the probability of electron tunneling, reduces contact resistance, improves the open-circuit voltage of solar cell 1, thereby enhancing the photoelectric conversion efficiency of the solar cell 1.

In addition, compared with the related art in which the stack structure of the solar cell only includes one layer of oxide layer and one layer of doped polycrystalline silicon layer, the stack structure of the solar cell 1 in the embodiments of the present disclosure may be provided with two layers of oxide layer and two layers of polycrystalline silicon layer, which can further improve the passivation effect of the solar cell 1, thereby further improving the working efficiency of the solar cell 1.

In other embodiments, three oxide layers and three polycrystalline silicon layers (not shown in the drawings) may also be provided in the stack structure of the solar cell, which can further improve the working efficiency of the solar cell. In one or more embodiments of the present disclosure, the specific number of arrangements of the oxide layers and polysilicon layers in the solar cell laminated structure is not limited, and may be adjusted according to actual conditions.

In some embodiments, as shown in FIG. 1 to FIG. 3, the preparation method of the solar cell 1 may include but is not limited to the following steps.

S11: a silicon substrate 11 is prepared. The silicon substrate contains antimony element.

S12: a first oxide layer 121, a first amorphous silicon layer 13, a second oxide layer 123 and a second amorphous silicon layer 14 is sequentially formed on a rear surface of the silicon substrate 11.

S13: a phosphorus doping process is performed, so as to convert the first amorphous silicon layer 13 into a first doped polycrystalline silicon layer 122, and to convert the second amorphous silicon layer 14 into a second doped polycrystalline silicon layer 124. Part of antimony element in the silicon substrate 11 is diffused into the first oxide layer 121, the first doped polycrystalline silicon layer 122, the second oxide layer 123 and the second doped polycrystalline silicon layer 124. An antimony doping concentration in the second oxide layer 123 is higher than an antimony doping concentration in the first doped polycrystalline silicon layer 122.

In some embodiments, by doping antimony element in the silicon substrate 11, antimony element in the silicon substrate 11 can diffuse out into the stack structure 12, which significantly improves the passivation effect of the stack structure 12, and enables antimony element in the stack structure 12 to have a certain concentration gradient characteristic, and can also improve the conductivity of carriers, thereby reducing the series resistance of the solar cell 1 and improving the working efficiency of the solar cell 1. Additionally, by doping antimony element in the silicon substrate 11, during the subsequent phosphorus doping process, antimony element in the silicon substrate 11 can automatically diffuse out into the stack structure 12 and form a certain concentration gradient characteristic under the influence of high temperature during the phosphorus doping process, thereby simplifying the preparation method of the solar cell 1 while meeting the usage requirement, and thus reducing the preparation difficulty.

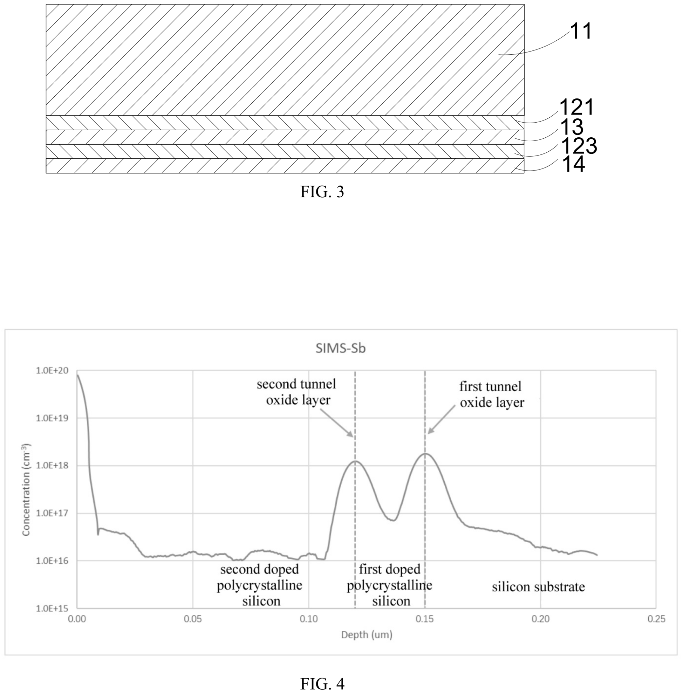

In some embodiments, as shown in FIG. 1 and FIG. 4, the first oxide layer 121, the first doped polycrystalline silicon layer 122, the second oxide layer 123, and the second doped polycrystalline silicon layer 124 may have different doping concentrations of antimony element.

In some embodiments, the doping concentrations of antimony element in the first oxide layer 121, the first doped polycrystalline silicon layer 122, the second oxide layer 123, and the second doped polycrystalline silicon layer 124 are different, thereby resulting in concentration gradient characteristics of antimony element in the structural layers of the stack structure 12, further increasing the conductivity of the carriers in the stack structure 12, reducing the series resistance of the solar cell 1, increasing the filling factor of the solar cell 1, improving the open-circuit voltage, and thus improving the working efficiency of the solar cell 1. Additionally, since the first oxide layer 121, the first doped polycrystalline silicon layer 122, the second oxide layer 123, and the second doped polycrystalline silicon layer 124 in the stack structure 12 are distributed along the thickness direction of the solar cell 1, during the process of diffusing out antimony element in the silicon substrate 11, the antimony doping concentration in each structural layer in the stack structure 12 can automatically form a gradually decreasing trend, so that the doping concentrations of antimony element in the four structural layers of the stack structure 12 are different from each other.

In some embodiments, as shown in FIG. 1 and FIG. 4, the antimony doping concentration in the first oxide layer 121 may be higher than the antimony doping concentration in the first doped polycrystalline silicon layer 122, and the antimony doping concentration in the second oxide layer 123 may be higher than the antimony doping concentration in the second doped polycrystalline silicon layer 124.

In some embodiments, the first oxide layer 121 and the second oxide layer 123 are configured to provide high-quality chemical passivation to passivate surface defects of the silicon substrate 11, so that the antimony doping concentration in the first oxide layer 121 is higher than the antimony doping concentration in the first doped polycrystalline silicon layer 122, and the antimony doping concentration in the second oxide layer 123 is higher than the doping concentration of antimony element in the second doped polycrystalline silicon layer 124. That is, in the stack structure, antimony element is mainly enriched in the first oxide layer 121 and the second oxide layer 123, with antimony element being able to occupy vacancies in the first oxide layer 121 and the second oxide layer 123, thereby reducing cross-sectional defects of the first oxide layer 121 and the second oxide layer 123, and thus improving the passivation effect. Additionally, enriching the first oxide layer 121 and the second oxide layer 123 with a relatively high content of antimony element can reduce the diffusion depth of the phosphorus element diffused into the stack structure 12 during the subsequent phosphorus diffusion process, thereby widening the process window. Additionally, the oxide layer and the doped polycrystalline silicon layer may have a doping concentration gradient characteristic of antimony element, thereby improving the conductivity of the carriers.

In some embodiments, as shown in FIG. 1 and FIG. 4, the antimony doping concentration in the first oxide layer 121 may be higher than the antimony doping concentration in the second oxide layer 123, and the antimony doping concentration in the second oxide layer 123 may be higher than the antimony doping concentration in the silicon substrate 11.

In some embodiments, the antimony doping concentration in the second oxide layer 123 is higher than the doping solubility of antimony element in the silicon substrate 11. That is, the antimony doping concentration in the first oxide layer 121 and the antimony doping concentration in the second oxide layer 123 are both higher than the antimony doping concentration in the silicon substrate 11, thereby enabling antimony element to be further enriched in the first oxide layer 121 and the second oxide layer 123, and thus significantly improving the passivation effect of the first oxide layer 121 and the second oxide layer 123.

In some embodiments, as shown in FIG. 1 and FIG. 4, the solar cell 1 may satisfy at least one of the following conditions. The antimony doping concentration in the first oxide layer 121 is in a range of 5.0×10¹⁶cm⁻³ to 2.0×10¹⁸cm⁻³. The antimony doping concentration in the second oxide layer 123 is in a range of 5.0×10¹⁶cm⁻³ to 2.0×10¹⁸cm⁻³. The antimony doping concentration in the first doped polycrystalline silicon layer 122 is in a range of 2.0×10¹⁶cm⁻³ to 6.0×10¹⁶cm⁻³. The antimony doping concentration in the second doped polycrystalline silicon layer 124 is in a range of 1.0×10¹⁶cm⁻³ to 2.0×10¹⁶cm⁻³ .

In some embodiments, the doping concentrations of antimony element of the first oxide layer 121, the first doped polycrystalline silicon layer 122, the second oxide layer 123, and the second doped polycrystalline silicon layer 124 meet the foregoing requirements. Additionally, the passivation effect of the stack structure 12 is effectively improved, the first oxide layer 121, the first doped polycrystalline silicon layer 122, the second oxide layer 123, and the second doped polycrystalline silicon layer 124 have a certain concentration gradient characteristic, so as to further improve the conductivity of the carriers in the stack structure 12, thereby improving the working efficiency of the solar cell 1.

In some embodiments, as shown in FIG. 1 and FIG. 4, step S13 may further specifically include the following steps.

S131: a phosphorus doping process is performed at a temperature of 850°C to 900°C.

In some embodiments, in the preparation process of the solar cell 1, when the phosphorus doping process is performed, the high temperature can simultaneously enable antimony element in the silicon substrate 11 to diffuse out into the stack structure 12, so that the temperature during the phosphorus doping process is in a range of 850°C to 900°C. Additionally, when preparing the silicon substrate 11, the antimony doping concentration in the silicon substrate 11 is in a range of 5.427×10¹⁶cm⁻³ to 2.042×10¹⁸cm⁻³, thereby conveniently controlling the concentration of antimony element diffusing out into the stack structure 12 to meet the usage requirements of the solar cell 1.

In addition, compared with the phosphorus doping process in the related art, in some embodiments of the present disclosure, during the phosphorus impurity deposition process prior to the phosphorus doping process, a constant-temperature process may be performed in a high-nitrogen environment (that is, an environment using pure nitrogen gas as a dilution gas) at a temperature of 800°C to 880°C for 200s to 400s, thereby giving antimony element in the silicon substrate 11 a driving force for diffusion, facilitating the subsequent diffusion of antimony element in the silicon substrate 11 into the stack structure 12, thus improving the conductivity of the carriers in the stack structure 12, and improving the working efficiency of the solar cell 1. In some embodiments, as shown in FIG. 1 and FIG. 3, step S12 may further specifically include the following steps.
S121: a LPCVD process is performed on the silicon substrate 11 by using a water vapor method to form a first oxide layer 121;
S122: a LPCVD process is performed on the first oxide layer 121 to form a first amorphous silicon layer 13;
S123: a LPCVD process is performed on the first amorphous silicon layer 13 by using a water vapor method to form a second oxide layer 123;
S124: a LPCVD process is performed on the second oxide layer 123 to form a second amorphous silicon layer 14.

In some embodiments, the semi-finished solar cell prepared by the above steps includes a silicon substrate 11, a first oxide layer 121, a first amorphous silicon layer 13, a second oxide layer 123 and a second amorphous silicon layer 14 which are sequentially stacked along the thickness direction of the solar cell 1. In the subsequent phosphorus doping process, the high-temperature annealing effect of the phosphorus doping process converts the first amorphous silicon layer 13 into the first doped polycrystalline silicon layer 122 and the second amorphous silicon layer 14 into the second doped polycrystalline silicon layer 124. Additionally, antimony element in the silicon substrate 11 also diffuse outs into the stack structure under the action of high temperature, thereby forming a passivation stack structure with excellent passivation effect and good contact performance. Additionally, by providing two layers of the oxide layer and two layers of the doped polycrystalline silicon layer in the solar cell 1, the passivation effect can be further improved, so as to significantly improve the working efficiency of the solar cell 1.

In some embodiments, as shown in FIG. 1, the first doped polycrystalline silicon layer 122 and the second doped polycrystalline silicon layer 124 may further include a phosphorus-containing layer.

In some embodiments, the silicon substrate 11 further includes phosphorus element. After the phosphorus doping process, phosphorus element in the silicon substrate 11 can diffuse into the first doped polycrystalline silicon layer 122 and the second doped polycrystalline silicon layer 124, so that the first doped polycrystalline silicon layer 122 and the second doped polycrystalline silicon layer 124 further include a phosphorus-containing layer. Additionally, antimony element is provided in the silicon substrate 11. During the phosphorus doping process, antimony element in the silicon substrate 11 can also diffuse out into the stack structure 12, so as to form more effective doping, thereby further improving the passivation effect, and reducing the diffusion depth of the phosphorus element during the phosphorus doping process, thus reducing the advancing time of phosphorus impurities and achieving a relatively low impurity level lower. Compared with the solar cell containing phosphorus element in the related art, the solar cell doped with phosphorus element and antimony element can also improve the open-circuit voltage, so as to improve the working efficiency of the solar cell 1.

The doping concentration of phosphorus element in the first doped polycrystalline silicon layer 122 and the second doped polycrystalline silicon layer 124 may be in a range of 1.0×10¹⁹cm⁻³ to 5.0×10²⁰cm⁻³.

In some embodiments, as shown in FIG. 1, the solar cell 1 may satisfy at least one of the following conditions. A thickness L1 of the first oxide layer 121 is in a range of 1nm to 2nm. A thickness L2 of the first doped polycrystalline silicon layer 122 is in a range of 100nm to 200nm. A thickness L3 of the second oxide layer 123 is in a range of 1nm to 2nm. A thickness L4 of the second doped polycrystalline silicon layer 124 is in a range of 100nm to 200nm.

In some embodiments, when the stack structure 12 includes two layers of the oxide layer and two layers of the doped polycrystalline silicon layer, the first oxide layer 121, the first doped polycrystalline silicon layer 122, the second oxide layer 123, and the second doped polycrystalline silicon layer 124 meet the foregoing thickness range, which can improve the passivation effect of the stack structure 12 while avoiding the situation that the thickness of the solar cell 1 is too large due to the too large overall thickness of the stack structure 12, thereby affecting the normal installation or use of the solar cell 1, and thus resulting in the relatively poor portability of the solar cell 1.

In some embodiments, as shown in FIG. 1 and FIG. 4, the solar cell 1 may satisfy at least one of the following conditions. The antimony doping concentration in the first oxide layer 121 gradually increases from a side facing the silicon substrate 11 to a side away from the silicon substrate 11. The antimony doping concentration in the first doped polycrystalline silicon layer 122 first decreases and then increases from a side facing the silicon substrate 11 to a side away from the silicon substrate 11. The antimony doping concentration in the second oxide layer 123 gradually decreases from a side facing the silicon substrate 11 to a side away from the silicon substrate 11. The antimony doping concentration in the second doped polycrystalline silicon layer 124 gradually decreases from a side facing the silicon substrate 11 to a side away from the silicon substrate 11.

In some embodiments, the doping concentrations of antimony element in the first oxide layer 121, the first doped polycrystalline silicon layer 122, the second oxide layer 123, and the second doped polycrystalline silicon layer 124 are different, thereby resulting in a certain concentration gradient characteristic of antimony element in different structural layers of the stack structure 12. Additionally, the doping concentrations of antimony elements in the first oxide layer 121, the first doped polycrystalline silicon layer 122, the second doped polycrystalline silicon layer 123, and the second doped polycrystalline silicon layer 124 vary with the thickness direction of the solar cell 1, so that each structural layer in the stack structure 12 has a certain antimony element concentration gradient characteristic, thereby further improving the conductivity of the carriers, and thus further improving the working efficiency of the solar cell 1.

In some embodiments, as shown in Table 1 below, the solar cell A is the solar cell 1 provided in one or more embodiments of the present disclosure, which is made of a phosphorus-antimony doped silicon wafer as a silicon substrate 11, and the stack structure 12 contains antimony element. The solar cell B is a solar cell provided in the related art, and is prepared of a pure phosphorus-doped silicon wafer as a silicon substrate. In addition, the solar cell A and the solar cell B adopt a same thickness and resistivity for their silicon substrates, and are prepared via a same process.

In some embodiments, test results of the solar cell A and the solar cell B are shown in Table 1 below. Compared with the solar cell B, the open-circuit voltage of the solar cell A is increased by 0.003V, the short-circuit current is decreased by 0.016A, the filling factor is improved by 0.26%, and the series resistance is reduced by -0.00023Ω. In summary, the overall working efficiency of the solar cell A is improved by 0.157% compared with that of the solar cell B. Therefore, compared with a solar cell B using a pure phosphorus-doped silicon substrate in the related art, the solar cell A (that is, the solar cell 1) provided in one or more embodiments of the present disclosure has higher working efficiency

**Table 1**

| Substrate | Working Efficiency Eta(%) | Open-Circuit Voltage Voc(V) | Short circuit-current Isc(A) | Filling Factor FF( %) | Series resistance Rs (Ω) |
|---|---|---|---|---|---|
| Solar Cell A (Phosphorus Antimony Doped) | 0.157 | 0.003 | -0.016 | 0.2 60 | -0.0002 3 |
| Solar Cell B (Pure Phosphorus Doped) | - | - | - | - | - |

## Claims

1. A solar cell (1), comprising a silicon substrate (11) and a stack structure (12); along a thickness direction of the solar cell (1), wherein the stack structure (12) is disposed on a rear surface of the silicon substrate (11); the silicon substrate (11) and the stack structure (12) comprise antimony; and
wherein the stack structure (12) at least comprises a first oxide layer (121), a first doped polycrystalline silicon layer (122), a second oxide layer (123) and a second doped polycrystalline silicon layer (124) which are stacked along the thickness direction of the solar cell (1); and
an antimony doping concentration in the second oxide layer (123) is higher than an antimony doping concentration in the first doped polycrystalline silicon layer (122).

2. The solar cell (1) according to claim 1, wherein the first oxide layer (121), the first doped polycrystalline silicon layer (122), the second oxide layer (123) and the second doped polycrystalline silicon layer (124) have different antimony doping concentrations from each other.

3. The solar cell (1) according to claim 2, wherein an antimony doping concentration in the first oxide layer (121) is higher than the antimony doping concentration in the first doped polycrystalline silicon layer (122).

4. The solar cell (1) according to claim 2, wherein the antimony doping concentration in the second oxide layer (123) is higher than an antimony doping concentration in the second doped polycrystalline silicon layer (124).

5. The solar cell (1) according to claim 3, wherein the antimony doping concentration in the first oxide layer (121) is higher than the antimony doping concentration in the second oxide layer (123).

6. The solar cell (1) according to claim 3, wherein the antimony doping concentration in the second oxide layer (123) is higher than an antimony doping concentration in the silicon substrate (11).

7. The solar cell (1) according to any one of claims 1 to 5, wherein the solar cell (1) satisfies at least one of the following conditions:
the antimony doping concentration in the first oxide layer (121) is in a range of 5.0×10¹⁶cm⁻³ to 2.0×10¹⁸cm⁻³, the antimony doping concentration in the second oxide layer (123) is in a range of 5.0×10¹⁶cm⁻³ to 2.0×10¹⁸cm⁻³.

8. The solar cell (1) according to claim 1, wherein the antimony doping concentration in the first doped polycrystalline silicon layer (122) is in a range of 2.0×10¹⁶cm⁻³ to 6.0×10¹⁶cm⁻³.

9. The solar cell (1) according to claim 1, wherein the antimony doping concentration in the second doped polycrystalline silicon layer (124) is in a range of 1.0×10¹⁶cm⁻³ to 2.0×10¹⁶cm⁻³

10. The solar cell (1) according to claim 1, wherein a thickness L1 of the first oxide layer (121) is in a range of 1 nm to 2 nm, and
a thickness L2 of the first doped polycrystalline silicon layer is in a range of 100 nm to 200 nm.

11. The solar cell (1) according to claim 1, wherein a thickness L3 of the second oxide layer (123) is in a range of 1 nm to 2 nm; and/or a thickness L4 of the second doped polycrystalline silicon layer is in a range of 100 nm to 200 nm.

12. The solar cell (1) according to claim 1, wherein a phosphorus doping concentration in the first doped polycrystalline silicon layer (122) and the second doped polycrystalline silicon layer 124 is in a range of 1.0×10¹⁹cm⁻³ to 5.0×10²⁰cm⁻³.

13. The solar cell (1) according to any one of claims 1 to 12, wherein the solar cell (1) satisfies at least one of the following conditions:
the antimony doping concentration in the first oxide layer (121) gradually increases from a side facing the silicon substrate (11) to a side away from the silicon substrate (11), the antimony doping concentration in the first doped polycrystalline silicon layer (122) first decreases and then increases from a side facing the silicon substrate (11) to a side away from the silicon substrate (11), the antimony doping concentration in the second oxide layer (123) gradually decreases from a side adjacent the silicon substrate (11) to a side distal to the silicon substrate (11), and the antimony doping concentration in the second doped polycrystalline silicon layer (124) gradually decreases from a side facing the silicon substrate (11) to a side away from the silicon substrate (11).

14. A method for preparing a solar cell (1), comprising:
preparing a silicon substrate (11) comprising antimony;
sequentially forming a first oxide layer (121), a first amorphous silicon layer (13), a second oxide layer (123) and a second amorphous silicon layer (14) on a rear surface of the silicon substrate (11); and
performing phosphorus doping to convert the first amorphous silicon layer (13) into a first doped polycrystalline silicon layer (122) and to convert the second amorphous silicon layer (14) into a second doped polycrystalline silicon layer (124),
wherein part of the antimony in the silicon substrate (11) is diffused into the first oxide layer (121), the first doped polycrystalline silicon layer (122), the second oxide layer (123) and the second doped polycrystalline silicon layer (124), and
an antimony doping concentration in the second oxide layer (123) is higher than an antimony doping concentration in the first doped polycrystalline silicon layer (122).

15. The method according to claim 14, wherein during the phosphorus doping, the method further comprises:
the phosphorus doping is performed at a temperature ranging from 850°C to 900°C.
